(19) Europäisches Patentamt

European Patent Office

Office européen des brevets

(11) **EP 1 039 477 B1**

(12) **FASCICULE DE BREVET EUROPEEN**

(45) Date de publication et mention
de la délivrance du brevet:
**18.05.2005 Bulletin 2005/20**

(51) Int Cl.⁷: **G11C 27/02**

(21) Numéro de dépôt: **00400677.1**

(22) Date de dépôt: **10.03.2000**

(54) **Echantillonneur bloqueur en technologie bipolaire complémentaire**

Abtast- und Halteschaltung in komplementärer Bipolartechnik

Sample and hold circuit using complementary bipolar technology

(84) Etats contractants désignés:
**DE FR GB IT NL**

(30) Priorité: **16.03.1999 FR 9903233**

(43) Date de publication de la demande:
**27.09.2000 Bulletin 2000/39**

(73) Titulaire: **Thales**
**75008 Paris (FR)**

(72) Inventeur: **Simony, Laurent,**
**c/o Thomson-CSF P.I, Dépt.Brevets**
**94117 Arcueil Cedex (FR)**

(74) Mandataire: **Guérin, Michel et al**
**THALES Intellectual Property,**
**31-33 avenue Aristide Briand**
**94117 Arcueil Cédex (FR)**

(56) Documents cités:
**EP-A- 0 851 434      US-A- 4 806 790**

## Description

L'invention concerne les échantillonneurs-bloqueurs utilisant une technologie bipolaire complémentaire.

Les échantillonneurs-bloqueurs sont utilisés dans de nombreux domaines de l'électronique et particulièrement dans les convertisseurs analogiques numériques et dans les chaînes de traitement de signal analogique.

La principale fonction d'un échantillonneur-bloqueur consiste à copier à partir d'un instant donné t0 et pendant une durée de temps $\Delta t$ très courte, le niveau d'une tension Vin appliquée à une entrée de l'échantillonneur-bloqueur et le mémoriser pendant un temps suffisamment long pour effectuer un traitement déterminé de ce niveau à t0. La durée $\Delta t$ est entendue très courte par rapport aux variations relatives de la tension d'entrée Vin.

L'échantillonneur-bloqueur peut prendre deux états différents correspondant à deux modes de fonctionnement différents.

Dans un premier état l'échantillonneur-bloqueur est en mode « suiveur » et une sortie de l'échantillonneur-bloqueur reproduit une image fidèle de la tension d'entrée Vin appliquée à son entrée.

Dans le second état l'échantillonneur-bloqueur est en mode « bloqué » et sa sortie est isolée de son entrée.

On définit un certain nombre de critères de qualité de l'échantillonneur-bloqueur, certains critères étant liés à l'un ou à l'autre mode de fonctionnement.

Par exemple, parmi les critères de qualité on peut citer en mode suiveur :

- le niveau maximum (pleine échelle) de la tension Vin pouvant être traitée par l'échantillonneur-bloqueur par rapport au niveau de la tension d'alimentation qui lui est appliquée. En effet un accroissement du niveau de la tension Vin pouvant être traitée conduit à une amélioration du rapport signal à bruit en sortie de l'échantillonneur-bloqueur et à une plus grande souplesse d'emploi ;
- la consommation : les performances dynamiques sont principalement liées aux courants de polarisation des différentes branches de l'échantillonneur-bloqueur. La tension étant imposée (par l'utilisateur), le concepteur cherche à minimiser le courant pour réduire la consommation.
- la linéarité : en mode suiveur il est important que la tension de sortie de l'échantillonneur-bloqueur soit une image fidèle de la tension d'entrée Vin et ceci sur la pleine échelle, c'est-à-dire du niveau maximum au niveau minimum de la tension Vin.
- la bande passante : exprime la faculté de l'échantillonneur à suivre un signal rapide, donc à être utilisé dans des applications exigeantes.
- le bruit : lorsqu'on échantillonne, on bloque en plus du signal Vin, le bruit propre de l'échantillonneur. Si le bruit possède un spectre s'étalant au-delà de celui du signal, le blocage ramène celui-ci en bande de base, c'est le repliement spectral. Il est donc indispensable de limiter la bande de bruit quand celle-ci n'est pas indispensable.
- la distorsion harmonique: elle peut être créée par une mauvaise linéarité mais aussi par des phénomènes réactifs. En particulier, le courant dynamique passant dans la capacité d'échantillonnage est une cause de non linéarité dynamique donc de distorsion.

Plus particulièrement en mode bloqué on peut citer :

- l'isolation entrée/sortie.
- la dérive : en général la tension échantillonnée à l'instant t0 est mémorisée à l'aide d'une capacité d'échantillonnage. Le signal en tension bloqué par la capacité d'échantillonnage est susceptible de dériver dans le temps par la présence de courants de fuite et du courant consommé par le dispositif de lecture de cette capacité. Cette dérive doit être faible, indépendante du niveau du signal et compatible avec la période d'échantillonnage et la pleine échelle du signal.
- vitesse de déblocage/blocage : la vitesse de commutation d'un état à l'autre est un paramètre important quant à l'utilisation en fréquence du circuit. Ce qui impose à l'échantillonneur de recevoir un signal d'une horloge commandant le changement d'état, de largeur minimale et qui fait que l'on réalise en réalité un suiveur-bloqueur et non un échantillonneur-bloqueur qui est idéalement commandé par une impulsion de Dirac.

Une caractéristique importante des échantillonneurs-bloqueurs est liée à la précision de la copie de la tension d'entrée Vin au moment du blocage.

La demande de brevet européen EPO 851 434 A2 décrit un système d'échantillonneur-bloqueur en technologie bipolaire qui améliore la précision de la valeur stockée sur la capacité d'échantillonnage en utilisant un amplificateur à réaction négative, et une disposition différentielle, afin de minimiser les erreurs d'échantillonnage.

En effet, la tension d'entrée Vin peut être appliquée sur la capacité d'échantillonnage à travers l'émetteur d'un transistor suiveur bipolaire. Au moment du blocage du transistor au temps t0, maintenant la tension Vin aux bornes de la capacité, la charge Qst stockée dans le transistor s'évacue en partie par la base et en partie par l'émetteur.

La charge stockée par un transistor bipolaire traversé par un courant de collecteur Ic, et de temps de transition Tf caractéristique de la technologie, est donnée par Qst=Ic.Tf. Quand on bloque le transistor, Ic devient nul et la charge évacuée par l'émetteur se trouve sur la capacité d'échantillonnage après le blocage, provoquant un décalage de la tension Vin (ou « pedestal » en langue anglaise).

La présente invention apporte des améliorations des performances des échantillonneurs-bloqueurs de l'art antérieur en proposant un échantillonneur-bloqueur comportant :

- un étage d'entrée suiveur ayant une entrée recevant une tension Vin à échantillonner et au moins une sortie,
- au moins un circuit d'échantillonnage ayant un étage de commutation, l'étage de commutation ayant au moins une entrée de commande, une entrée de signal reliée à la sortie de l'étage d'entrée suiveur, et une sortie. L'étage de commutation est commandé par son entrée de commande par une commande numérique pour être mis, soit dans un premier état dit « suiveur » où sa sortie suit le potentiel sur son entrée de signal, soit dans un deuxième état dit « isolé » où sa sortie est isolée de son entrée de signal. La sortie de l'étage de commutation est connectée à la base d'un premier transistor suiveur dont l'émetteur est relié à une borne d'une capacité d'échantillonnage de sortie. Le circuit d'échantillonnage comporte encore un deuxième transistor ayant son émetteur alimenté par une source de courant et ayant sa base reliée à un potentiel recopiant celui de la borne de la capacité d'échantillonnage de sortie et un troisième transistor commandé par la commande numérique de manière à être parcouru par un courant lorsque l'étage de commutation est dans l'état « isolé » et de manière à être bloqué lorsque l'étage de commutation est dans l'état « suiveur », le troisième transistor ayant son émetteur relié à la base du premier et sa base reliée à l'émetteur du deuxième.

Pour recopier sur la base du deuxième transistor le potentiel de la capacité d'échantillonnage de sortie, l'échantillonneur-bloqueur comporte de préférence une capacité d'échantillonnage additionnelle et un quatrième transistor suiveur ayant sa base reliée à la sortie de l'étage de commutation et son émetteur relié à une borne de la capacité d'échantillonnage additionnelle pour appliquer à cette borne une tension recopiant le potentiel sur la borne de la capacité d'échantillonnage de sortie, la base du deuxième transistor étant reliée à la base de la capacité d'échantillonnage additionnelle.

Dans cette réalisation, l'échantillonneur-bloqueur comporte deux capacités liées à la fonction d'échantillonnage : la capacité d'échantillonnage de sortie connectée exclusivement à un amplificateur de lecture de la tension échantillonnée et la capacité d'échantillonnage additionnelle, de valeur plus faible que la capacité d'échantillonnage de sortie. La tension aux bornes de la capacité d'échantillonnage additionnelle s'établit plus rapidement que la tension aux bornes de la capacité d'échantillonnage de sortie, ce qui permet de fixer plus rapidement les potentiels inverses de blocage des transistors. Le blocage de l'échantillonneur-bloqueur est ainsi anticipé, ce qui permet d'obtenir des paliers d'échantillonnage plus propres et une meilleure isolation.

En résumé le fait de disposer en plus de la capacité d'échantillonnage de sortie, d'une capacité d'échantillonnage additionnelle aux bornes de laquelle se trouve recopié le signal échantillonné, permet d'éviter d'injecter sur la capacité d'échantillonnage de sortie les perturbations dues au blocage des transistors qui n'affectent que la capacité d'échantillonnage additionnelle.

Dans une réalisation selon l'invention de l'échantillonneur-bloqueur en technologie de type complémentaire, et dans un même circuit d'échantillonnage, les premier et troisième transistors sont d'un premier type et le deuxième transistor est de type complémentaire.

L'étage d'entrée suiveur peut être réalisé de façon à ce qu'il effectue une recopie de la tension Vin avec un décalage de tension tel qu'il annule un décalage de tension dans un sens contraire dû à la structure électrique du circuit d'échantillonnage, ce qui comporte l'avantage d'obtenir la même tension continue à l'entrée et à la sortie de l'échantillonneur-bloqueur.

Dans une autre réalisation, deux circuits d'échantillonnage symétriques sont utilisés pour constituer un échantillonneur-bloqueur symétrique. L'étage d'entrée suiveur comporte dans ce cas deux sorties recopiant la tension d'entrée Vin, une première sortie avec un décalage de tension positif et une seconde sortie avec un décalage de tension négatif par rapport à l'entrée de l'échantillonneur-bloqueur. Ces deux sorties sont reliées à la borne de la capacité d'échantillonnage de sortie par des circuits symétriques, un premier circuit d'échantillonnage comprenant un premier étage de commutation et les premier, deuxième, troisième et quatrième transistors et un second circuit d'échantillonnage constitué de manière identique au premier mais à partir de transistors de type complémentaires de ceux qui sont utilisés dans le premier circuit.

Le principe de fonctionnement de l'échantillonneur-bloqueur, selon l'invention sera mieux compris en le décomposant en blocs fonctionnels élémentaires que l'on retrouvera par la suite dans une description complète de cette réalisation.

L'échantillonneur-bloqueur fonctionne en mode suiveur-bloqueur.

<u>En mode suiveur</u> :

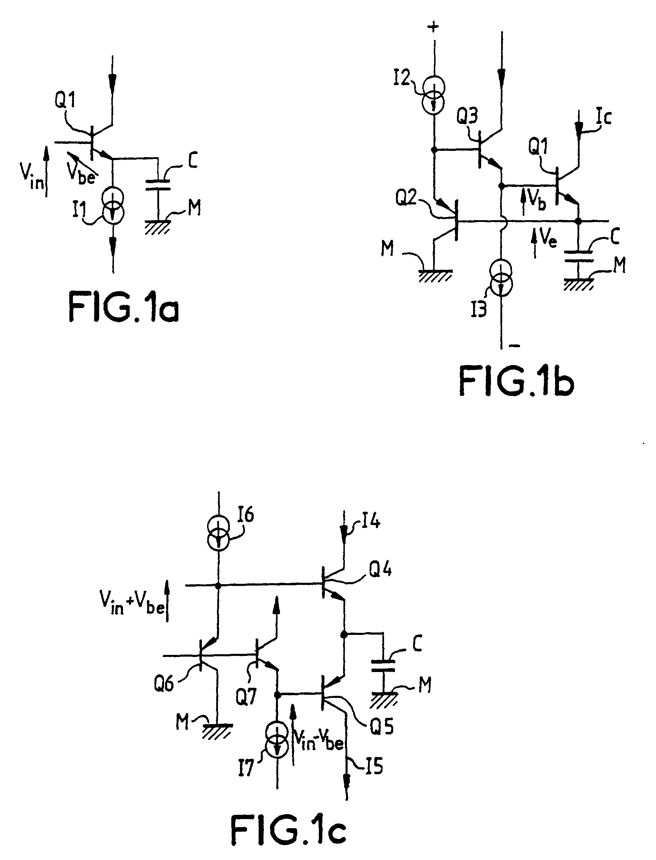

La figure 1a montre un bloc de base comportant un transistor suiveur Q1, par exemple de type NPN, connecté par son émetteur à une borne d'une capacité d'échantillonnage C, l'autre borne étant reliée à une masse M.

Le transistor suiveur Q1 reçoit par sa base la tension à échantillonner Vin et à mémoriser par la capacité d'échantillonnage C.

La jonction base émetteur est polarisée à courant constant par un générateur de courant I1. La tension V(c) aux bornes de la capacité d'échantillonnage est :

$$V(c) = Vin - Vbe,$$

avec Vbe>0

Vbe étant la tension base/émetteur du transistor Q1.

<u>En mode bloqueur</u> :

Il faut donc bloquer le transistor suiveur Q1 de la figure 1a. Pour cela, la source de courant I1, active en mode suiveur, est alors coupée.

Le schéma de base de la figure 1b comportant deux autres transistors Q2 et Q3 et deux sources de courant 12 et 13 permet de réaliser la fonction de blocage de l'échantillonneur.

Le transistor suiveur Q3, de même type NPN que le transistor Q1, se trouve connecté par son émetteur à la base du transistor suiveur Q1 connecté par son émetteur à la capacité d'échantillonnage C. La jonction base-émetteur du transistor Q3 est polarisée par un générateur de courant 13 relié à une source d'alimentation négative. Le transistor Q2 de type complémentaire PNP est relié par son collecteur à la masse M, et par son émetteur, d'une part à la base du transistor suiveur Q3 et d'autre part à une source de courant 12 connectée à une source d'alimentation positive, la base du transistor Q2 étant reliée à l'émetteur du transistor Q1.

En mode bloqué, on isole la capacité d'échantillonnage C. Il faut pour cela bloquer le transistor suiveur Q1. Ceci est obtenu par l'annulation de son courant en rendant sa tension base-émetteur Vbe négative ou nulle. Dans notre cas on la rend sensiblement nulle grâce au montage de la figure 1b.

Dans le montage de la figure 1b on a alors :

$$Vb = Ve+|Vbe(Q2)| -|Vbe(Q3)| = 0 \text{ volts}$$

Vb et Ve étant les tension base et émetteur du transistor Q1

Vbe(Q2) et Vbe(Q3) les tensions base-émetteur des transistors Q2 et Q3.

La tension Vb du transistor Q1 est nulle à quelques millivolts près, mais ceci est suffisant pour assurer son blocage.

La variation de la tension base-émetteur Vbe(Q1) entre le mode suiveur et le mode bloqué vaut Vbe et cette variation est indépendante de la tension d'entrée Vin.

Par ailleurs la charge stockée Qst dans le transistor suiveur Q1 est :

- avant blocage :

$$Qst = Ic (Q1) *Tf,$$

avec
   Ic (Q1) : courant collecteur dynamique de Q1
   Tf : temps de transit dans le transistor Q1

- après blocage : Qst est nulle car plus de courant

$$Ic (Q1) = Ipolar + C.dVin/dt$$

avec Ipolar : courant de polarisation de collecteur (sans variations de la tension d'entré Vin).

On suppose toujours pour obtenir une distorsion correcte que Ipolar est beaucoup plus grande que C.dVin/dt, ce qui permet de dire que Ic(Q1) est sensiblement constant. Ainsi la variation de charge stockée est constante, donc indépendante de la tension d'entrée Vin.

Au moment du blocage, cette charge stockée s'évacue du transistor Q1 par la base et par l'émetteur. La répartition des charges entre base et émetteur dépend des impédances respectives en ces points. Ces impédances sont les suivantes :

Sur l'émetteur du transistor Q1, il ne reste que la capacité d'échantillonnage C, la source de courant I3 étant coupée, l'impédance est capacitive fixe.

Sur la base du transistor Q1, l'impédance est assurée par l'émetteur du transistor Q3 polarisé en suiveur, l'impédance constante valant Ut/Ic, avec Ut =kT/q et donc indépendante du niveau du signal.

    k , étant la constante de Boltzmann,

    T, la température absolue et

    q, la charge de l'électron.

Ainsi, au moment du blocage du transistor Q1, la charge stockée (indépendant de la tension d'entrée Vin) s'évacue en fonction d'un rapport d'impédances fixe.

Le piédestal étant provoqué par la fraction de charges s'évacuant par l'émetteur du transistor Q1, celui-ci est donc fixe et indépendant du niveau de la tension d'entrée Vin.

Ceci est un point important pour obtenir une faible distorsion.

De plus, par l'aspect complémentaire d'une configuration symétrique de l'échantillonneur-bloqueur, qui sera décrite par la suite, comportant deux transistors suiveurs de technologie complémentaire connectés sur la capacité d'échantillonnage, les charges dues à ces deux transistors étant de signes opposés, c'est la différence de ces charges qui se retrouve sur la capacité. Ceci a pour effet de diminuer la valeur absolue du piédestal par un rapport 5 à 10 environ.

On peut aussi remarquer que le niveau de blocage est créé par deux transistors suiveurs Q1 et Q3 seulement. Ce niveau se crée donc extrêmement rapidement dès lors que l'on passe en mode bloqué, par opposition à des solutions de l'art antérieur où ce niveau est créé à partir d'un amplificateur, ce qui est nécessairement plus long et entraîne un risque d'instabilité (oscillations).

Avec la source de courant I1 constante (Classe A), pour alimenter le transistor Q1, on a besoin d'une forte consommation, car il faut que I1 >C.(dVin/dt)max.

En adoptant le montage représenté à la figure 1c, on s'affranchit de cette contrainte. Ce montage comporte deux transistors suiveurs Q4 et Q5 de types complémentaires, par exemple respectivement de types NPN et PNP ayant leurs émetteurs connectés à la capacité C d'échantillonnage, le collecteur du transistor Q4 étant connecté à une source d'alimentaion positive et le collecteur du transistor Q5 à une source d'alimentation négative.

Un transistor Q6 de même type PNP que le transistor suiveur Q5 a son émetteur connecté d'une part à une source de courant I6 reliée à la source d'alimentation positive et d'autre part à la base du transistor Q4, son collecteur étant connecté à la masse M.

Un transistor Q7 de même type NPN que le transistor Q4, a son émetteur connecté d'une part à une source de courant I7 reliée à la source d'alimentation négative et d'autre part à la base du transistor Q5, son collecteur étant sous un potentiel d'alimentation positif. Les bases des transistors Q6 et Q7 sont reliées entre elles.

Dans ce type de montage «symétrique» les bases des transistors suiveurs Q4 et Q5 (NPN et PNP) doivent être pilotées respectivement par des niveaux (Vin + Vbe) et (Vin - Vbe), ces « Vbe » étant définis afin de contrôler le courant passant dans les transistors NPN et PNP.

Le principe est d'utiliser une boucle dite « translinéaire », c'est-à-dire une boucle de jonctions base-émetteur.

Rappel du principe:

Pour une jonction base-émetteur, la relation tension courant est de la forme :

$$Vbe = Ut * ln (I/Is)$$

où

    I : courant dans le transistor

    Is: courant de saturation inverse

    ln : logarithme népérien.

Dans le schéma de la figure 1c, on a une boucle fermée de Vbe.

On écrit que la somme de ces Vbe en parcourant la boucle est nulle :

$$Vbe(Q6) - Vbe(Q4) - Vbe(Q5) + Vbe(Q7) = 0$$

soit :

$$Ut.ln(I6/Isp) - Ut.ln(I4)/Isn) - Ut.ln(I5/Isp) + Utlin(I7/Isn) = 0$$

avec : Isp : courant de saturation inverse des transistors PNP
Isn : courant de saturation inverse des transistors NPN
I4,I5,I6,I7 courants dans les transistors Q4,Q5,Q6,Q7
d'où : I6.I7 = I4.I5

Comme, à l'équilibre, on a : I4 = I5, on trouve I4 = I5 = sqrt (I6.I7) (sqrt = racine carrée). Ceci contrôle la consommation de repos.

Pour le schéma complet de l'échantillonneur, on fera une boucle constituée de huit transistors (quatre pour le schéma de principe de la figure 1 c) mais le principe est le même.

En dynamique, si Vin varie positivement (échelon de tension), 14 augmente exponentiellement et I5 diminue exponentiellement (transitoirement), le potentiel sur la capacité C d'échantillonnage se réajuste, et on tend vers un nouvel état d'équilibre.

Ainsi, lorsque Vin varie par paliers comme par exemple dans le cas du signal d'un dispositif à couplage de charges « CCD », il est possible, d'obtenir une bonne efficacité (courant dynamique/courant statique).

Pour un échantillonnage d'un signal aléatoire, il faut prendre un courant de repos plus grand par rapport à C. dVin/dt pour régler la distorsion harmonique (la charge stockée et les Vbe n'étant pas constants).

Le circuit de la figure 1c permet une amélioration de l'efficacité dans le cas de signaux par paliers (c'est-à-dire pour une pente dVin/dt négligeable à l'instant du blocage).

Des résistances dans les émetteurs des transistors suiveurs connectés à la capacité d'échantillonnage permettent :

- de réduire fortement le courant de repos, d'où une baisse de la consommation du circuit.
- diminuer le bruit sur le signal échantillonné.
- limiter l'effet inductif de l'émetteur (évite des oscillations locales transitoires).

L'échantillonneur-bloqueur dans une réalisation selon l'invention citée précédemment, utilise deux capacités d'échantillonnage que nous avons désignées, l'une, capacité d'échantillonnage de sortie, jouant le rôle de la capacité d'échantillonnage des figures 1a,1b,1c et l'autre, capacité d'échantillonnage additionnelle, sur laquelle on reviendra plus loin

En se référant au montage de base de la figure 1b, en mode bloqueur, le transistor Q2 est polarisé en permanence, mais le transistor Q3 est commuté, se débloquant au moment du passage en mode bloqué de la structure.

Il s'ensuit un appel de courant de base du transistor Q3, qui inévitablement perturbe aussi le transistor Q2, et donc le signal échantillonné.

Pour disposer d'un signal de sortie non perturbé par cet effet, le signal utile sera prélevé sur la capacité d'échantillonnage de sortie pilotée par d'autres transistors suiveurs commandés en parallèle avec les transistors suiveurs pilotant la capacité d'échantillonnage additionnelle. Ainsi :

- Les niveaux fournis sur la base des suiveurs pilotant la capacité d'échantillonnage de sortie sont créés par les suiveurs pilotant la capacité d'échantillonnage additionnelle.

La capacité d'échantillonnage de sortie ne subit pas les perturbations occasionnées par la commutation, celles-ci ne se trouvant que sur la capacité d'échantillonnage additionnelle.

Si on ralentit quelque peu le signal sur la capacité d'échantillonnage de sortie (capacité d'échantillonnage de sortie plus grande que la capacité d'échantillonnage additionnelle), et éventuellement on ajoute des résistances dans les émetteurs des transistors suiveurs, comme décrit plus haut, les niveaux de tension fournis par le transistor suiveur Q1 (ou les transistors suiveurs Q4 et Q5 dans le cas d'une réalisation symétrique) sur les bases des transistors pilotant la capacité d'échantillonnage additionnelle sont « anticipés ».

Ainsi, le principe d'avoir une variation constante de tension Vbe pour le suiveur au moment du blocage (tel que décrit précédemment, figure 1a) est d'autant mieux vérifié pour la capacité d'échantillonnage additionnelle. En effet, pour cette capacité au moment du blocage, les niveaux assurant le blocage ne sont pas en train de s'établir, mais sont déjà établis.

D'autres caractéristiques et avantages de l'invention apparaîtront à la lecture de la description détaillée qui en est faite en référence aux figures annexes dans lesquelles :

- Les figures 1a,1b,1c déjà décrites montrent des schémas de base d'éléments de l'échantillonneur-bloqueur selon l'invention.
- La figure 2 représente un schéma électrique d'un échantillonneur-bloqueur symétrique, selon l'invention.
- La figure 3a montre les éléments du schéma électrique assurant le mode bloqué de l'échantillonneur-bloqueur.
- La figure 3b montre le schéma petits signaux des éléments de la figure 3a permettant d'évaluer l'isolement en mode bloqué.

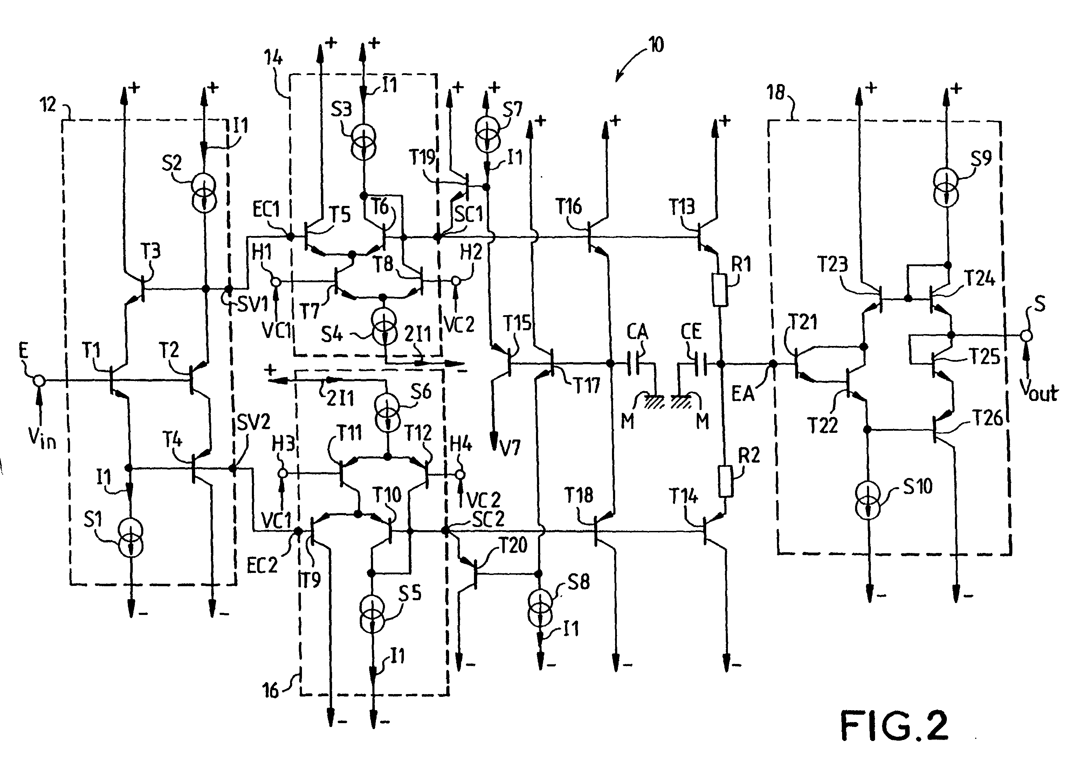

La figure 2 montre le schéma électrique d'un échantillonneur-bloqueur 10, selon l'invention, comportant un étage d'entrée suiveur 12 ayant une entrée E à laquelle est appliquée une tension d'entrée Vin à échantillonner. L'étage d'entrée 12 fournit deux sorties en suiveur, une première sortie SV1 recopiant le signal Vin avec un décalage positif de tension par rapport à son entrée E et une seconde sortie SV2 recopiant le signal Vin avec un décalage négatif de la tension par rapport à cette même entrée E, le décalage positif et le décalage négatif ayant des amplitudes sensiblement identiques.

Les deux sorties SV1 et SV2 de l'étage d'entrée suiveur sont reliées à une borne d'une capacité d'échantillonnage de sortie CE par un circuit d'échantillonnage de constitution symétrique à deux voies, qu'on appellera ci-après, premier et second circuit d'échantillonnage, le second étant constitué de manière identique au premier mais à partir de transistors de type complémentaires de ceux qui sont utilisés dans le premier circuit.

L'échantillonneur-bloqueur 10 comporte une source d'alimentation positive et une source d'alimentation négative, non représentées sur la figure 2, pour l'alimentation de ses différents circuits.

L'entrée E de l'étage d'entrée suiveur est reliée d'une part, à sa première sortie SV1 par la base d'un transistor suiveur T1 de type NPN dont l'émetteur se trouve connecté à une première source de courant d'entré S1 alimentée par la source d'alimentation négative et par l'émetteur d'un transistor suiveur T2 de type complémentaire au transistor suiveur T1, soit de type PNP, l'émetteur du transistor suiveur T2 de type PNP étant connecté à une seconde source de courant d'entrée S2 alimentée par la source d'alimentation positive, et sa base reliée à l'entrée E de l'étage suiveur d'entrée 12. L'entrée E de l'étage d'entrée suiveur 12 est reliée d'autre part à sa seconde sortie SV2 par l'émetteur du transistor suiveur T1 de type NPN.

Les première et seconde sources de courant d'entrée (S1,S2) imposant sensiblement les mêmes courants de polarisation I1 dans les transistors, faisant apparaître des potentiels de polarisation Vbe, entre la base et l'émetteur de chaque transistor, sensiblement identiques.

Une tension Vin appliquée à l'entrée E de l'étage d'entrée suiveur 12 fournit à sa première sortie SV1 une tension Vin décalée positivement (ou vers le haut) de la tension émetteur base du transistor suiveur T2 et à sa seconde sortie SV2, une tension Vin décalée négativement (ou vers le bas), de la tension émetteur base du transistor suiveur T1 par rapport à l'entrée E. Ces deux tensions attaquent les deux circuits d'échantillonnage symétriques de l'échantillonneur-bloqueur 10.

Un transistor T3 de type NPN, dont le collecteur est relié à la source d'alimentation positive est connecté par son émetteur au collecteur du transistor suiveur T1 et par sa base à l'émetteur du transistor suiveur T2.

Le courant dans le transistor T3 se trouve imposé par la première source de courant d'entrée S1 à une valeur I1, les transistors T1, T2 et T3 présentant des potentiels Vbe sensiblement identiques pour le courant I1.

Dans cette configuration, la tension entre la base et l'émetteur du transistor T3 est sensiblement identique à la tension entre l'émetteur et la base du transistor suiveur T2, soit (Vin+Vbe), ce qui conduit à une tension Vcb entre le collecteur et la base du transistor suiveur T1 sensiblement nulle.

Un transistor T4 de type PNP ayant son collecteur relié à la source d'alimentation négative est connecté par son émetteur au collecteur du transistor suiveur T2 de type PNP, et par sa base à l'émetteur du transistor suiveur T1 de type NPN.

De la même façon, la tension entre la base et l'émetteur du transistor suiveur T1 est sensiblement identique à la tension entre l'émetteur et la base du transistor T4, soit (Vin-Vbe), ce qui conduit à une tension sensiblement nulle entre le collecteur et la base du transistor suiveur T2.

Dans certaines applications, il est souhaitable d'avoir une capacité d'entrée faible et indépendante du niveau d'entrée.

L'étage d'entrée suiveur 12 de l'échantillonneur-bloqueur 10 selon l'invention, comporte l'avantage de présenter une capacité d'entrée Ce de valeur quasiment nulle. En effet les capacités connectées sur l'entrée E de l'échantillonneur-bloqueur sont les capacités base-émetteur (Cbe) et base-collecteur (Cbc) des transirtors suiveurs d'entrée T1 et T2. Les tensions sur ces capacités sont respectivement Vbe et Vbc ; on à :

Vbe = constante car les transistors sont polarisés par un courant constant I1
Vbc = constante car égale à la difference de deux tensions Vbe ellles-mêmes constantes.

Les appels de courants dynamiques i dans l'entrée du circuit sont

i = Cbe.dVbe/dt + Cbc.dVbc/dt Vbe et Vbc étant constante on à i = 0

or i = Ce.dVin/dt avec Ceq = capacité équivalente de l'entrée E donc Ce = 0

La première sortie SV1 de l'étage d'entrée suiveur 12 attaque une entrée EC1 du premier étage de commutation 14 du premier circuit d'échantillonnage, la seconde sortie SV2 de l'étage d'entrée suiveur (12) attaquant une entrée EC2 d'un second étage de commutation 16 du second circuit d'échantillonnage symétrique du premier.

Le premier étage de commutation comporte une sortie SC1 et deux entrées de commande, une première entrée de commande H1 et une seconde entrée de commande H2, ces deux entrées étant attaquées respectivement par des signaux de commutation complémentaires VC1 et VC2 fournis par une commande numérique (en pratique une horloge). Le premier étage de commutation 14 comporte en outre un premier transistor suiveur T5 de type NPN et un second transistor suiveur T6 de même type NPN, dont les émetteurs sont reliés entre eux, le collecteur du premier transistor suiveur T5 étant relié à la source d'alimentation positive et le collecteur du second transistor suiveur T6 à une source de courant S3 de valeur I1 alimentée par la source d'alimentation positive, la base du premier transistor suiveur T5 étant reliée à l'entrée EC1 du premier l'étage de commutation 14 et la base du second transistor suiveur T6 étant reliée à la sortie SC1 du même premier étage de commutation 14.

Un premier transistor de commutation T7 et un second transistor de commutation T8 ont leurs émetteurs reliés à une source de courant S4 de valeur 2.I1 alimentée par la source d'alimentation négative, le premier transistor de commutation T7 ayant son collecteur relié aux émetteurs des transistors suiveurs T5 et T6 du premier étage de commutation, et sa base à la première entrée de commande H1, le second transistor de commutation T8 ayant son collecteur relié à la base et au collecteur du second transistor suiveur T6 et sa base à la seconde entrée de commande H2.

L'étage de commutation a pour rôle de faire suivre la tension Vin en mode « suiveur » et d'isoler l'entrée de la sortie en mode « bloqueur ».

Quand la tension différentielle (VC1-VC2) est supérieure à la tension de commutation d'une paire différentielle, soit environ une tension de 10.kT/q volts, tout le courant 2.I1 passe dans le transistor T7. La paire différentielle constituée par les transistors suiveurs T5 et T6 est à l'équilibre car il passe donc dans le transistor suiveur T5 un courant égal à 2.I1-I1=I1 donc la tension à la sortie SC1 est égale à la tension Vin à l'entrée EC1.

Quand la tension différentielle (VC1-VC2) est inférieure à la tension de commutation d'une paire différentielle (environ 10.kT/q volts), tout le courant 2.I1 bascule dans le transistor T8. La paire différentielle (transistors suiveurs T5 et T6) n'as plus de courant et n'impose donc plus le potentiel en sortie SC1. Il faut donc assurer un potentiel provoquant le blocage par un transistor du circuit d'échantillonnage, décrit plus loin, qui fournit le courant.

Dans le second circuit d'échantillonnage, le second étage de commutation 16, symétrique du premier étage de commutation 14 est réalisé de façon identique au premier mais à partir de transistors T9,T10,T11 et T12 de type PNP complémentaires de ceux du premier étage de commutation 14 et de deux sources de courant S5 et S6 respectivement de valeur I1 et 2.I1.

Dans le premier circuit d'échantillonnage, la sortie de commutation SC1 du premier étage de commutation 14 attaque la base d'un premier transistor suiveur T13 de type NPN et ayant son collecteur relié à la source d'alimentation positive et son émetteur relié à une première borne de la capacité d'échantillonnage de sortie CE à travers une résistance R1, une seconde borne de cette capacité étant connectée à une masse M de l'échantillonneur-bloqueur 10. Un transistor T15 de type PNP, polarisé par son emetteur par une source de courant S7 de valeur I1, a sa base reliée à une première borne d'une capacité d'échantillonnage additionnelle CA, la première borne de cette capacité étant connectée à l'émetteur d'un second transistor suiveur T16 de type NPN ayant son collecteur relié à la source d'alimentation positive et sa base reliée à la sortie SC1 du premier étage de commutation 14. Une seconde borne de la capacité d'échantillonnage additionnelle CA est connectée à la masse M de l'échantillonneur-bloqueur.

Un transistor T19 de type NPN (jouant le rôle de « clamp ») est relié par son collecteur à la source d'alimentation positive, par son émetteur à la sortie SC1 du premier étage de commutation 14 et par sa base à l'émetteur du transistor T15 de type PNP.

De la même façon, dans le second circuit d'échantillonnage, la sortie de commutation SC2 du second étage de commutation 16 attaque la base d'un premier transistor suiveur T14 de type PNP ayant le collecteur relié à la source d'alimentation négative et son émetteur relié à la première borne de la capacité d'échantillonnage de sortie CE à travers une résistance R2 du second circuit d'échantillonnage, de valeur sensiblement identique à la valeur de la résistance R1 du premier circuit d'échantillonnage, la seconde borne de la capacité d'échantillonnage de sortie CE étant connectée à une masse M de l'échantillonneur-bloqueur.

Un transistor T17 de type NPN est relié par son émetteur à une source de courant S8 de valeur I1 alimentée par la source d'alimentation négative, par son collecteur à la source d'alimentation positive et par sa base à la même première borne de la capacité d'échantillonnage additionnelle CA, la première borne de la capacité d'échantillonnage additionnelle CA étant connectée à l'émetteur d'un second transistor suiveur T18 de type PNP son collecteur étant relié à la source d'alimentation négative et sa base étant reliée à la sortie SC2 du second étage de commutation 16.

Un transistor T20 de type PNP est relié par son collecteur à la source d'alimentation négative, par son émetteur à la sortie SC2 du second étage de commutation 16 et par sa base à l'émetteur du transistor T17 de type NPN.

On peut remarquer, que les transistors T16,T15 et T19 ou leurs complémentaires T18,T17 et T20 dans le circuit symétrique ont respectivement les mêmes fonctionnalités que les transistors Q1,Q2 et Q3 des blocs élémentaires des figures 1a et 1b décrivant les principes de fonctionnement.

Nous allons par la suite décrire le fonctionnement détaillé de l'échantillonneur bloqueur 10 à l'aide de la figure 2, et en particulier le fonctionnement du premier circuit échantillonneur, le second circuit fonctionnant d'une manière identique.

1) L'Echantillonneur-bloqueur est dans l'état « suiveur »:

Dans cet état, la tension de commutation VC1 appliquée par la commande numérique à la première entrée de commutation H1 est dans un état haut rendant conducteur le transistor de commutation T7 et la tension de commutation complémentaire VC2, appliquée par la même commande numérique à la seconde entrée de commutation H2, est à l'état bas bloquant le second transistor de commutation T8.

Les émetteurs des deux transistors suiveurs T5 et T6 sont dans un état passant et le courant de collecteur dans chaque transistor est sensiblement identique à I1. Le potentiel (Vin+Vbe), à l'entrée EC1 du premier étage de commutation 14 se trouve reproduit à sa sortie SC1. Les bases des transistor suiveurs T13 et T16 se trouvent au potentiel (Vin+Vbe), et dans l'état «suiveur» la tension aux bornes de la capacité d'échantillonnage de sortie CE, après le décalage en tension d'une valeur sensiblement égale à la tension base-émetteur (Vbe) de l'un ou de l'autre des transistors suiveurs T13 ou T16, devient alors :

$$(Vin+ Vbe) -Vbe = Vin.$$

Les décalages de tension entre l'entrée E et la capacité d'échantillonnage de sortie s'annulant (+Vbe puis -Vbe), le niveau continu à l'entrée E de l'étage suiveur 12 et aux bornes de la capacité d'échantillonnage de sortie CE est sensiblement le même.

L'émetteur du transistor T19 est au potentiel (Vin+Vbe), soit le potentiel à la sortie SC1 du premier étage de commutation 14, et sa base au potentiel de l'émetteur du transistor T15 polarisé par la source de courant S7 de façon à obtenir la tension Vbe, ce potentiel étant (Vin+Vbe), le potentiel base-émetteur du transistor T19 est (Vin +Vbe) - (Vin+Vbe), soit sensiblement égal à 0 volts, le transistor T19 est par conséquence à l'état bloqué.

2) L'Echantillonneur-bloqueur est dans l'état « bloqué »:

L'échantillonneur-bloqueur 10 est basculé à un instant t0 dans l'état « bloqué » par le changement d'état des tensions de commutation VC1 et VC2.

Dans cet état «bloqué », la tension de commutation VC1 appliquée par la commande numérique à la première entrée de commutation H1 est dans un état bas bloquant le premier transistor de commutation T7, et la tension de commutation complémentaire VC2 appliquée par la même commande numérique à la seconde entrée de commutation H2 est à l'état haut saturant le second transistor de commutation T8 traversé par le courant I1 de la source de courant S3.

Les émetteurs des deux transistors suiveurs T5 et T6 sont isolés de la source de courant S4 et le courant de collecteur dans chaque transistor est nul. La sortie SC1 du premier étage de commutation 14 est alors isolée de son entrée EC1.

Le courant de valeur 2.I1 fourni par la source de courant S4 provient d'une part du courant I1 dans le second transistor de commutation T8 à l'état saturé et d'autre part du transistor T19 qui en devenant passant est traversé par un courant de sensiblement même valeur I1.

Le courant dans le transistor T15 fourni par le générateur de courant S7 reste inchangé, sa tension base étant la tension Vin aux bornes de la capacité d'échantillonnage additionnelle CA et le potentiel de son émetteur étant (Vin+Vb). La tension base du transistor T19 étant (Vin +Vbe), son émetteur se trouve par conséquent au potentiel Vin. Les bases ainsi que les émetteurs des transistors suiveurs T13 et T16 se trouvant au même potentiel Vin, ces transistors sont bloqués produisant l'isolement de la capacité d'échantillonnage additionnelle CA et de la capacité d'échantillonnage de sortie CE.

Quand l'échantillonneur bloqueur passe du mode « suiveur » au mode « bloqué », à l'instant t0, une perturbation gênante est provoquée par les appels de courant des bases des transistors T15 et T17 sur la capacité d'échantillonnage additionnelle CA. Il n'existe pas de tels transistors connectés sur la capacité d'échantillonnage de sortie CE.

La capacité d'échantillonnage additionnelle CA étant de valeur plus petite que la capacité d'échantillonnage de sortie CE, et les émetteurs des seconds transistors d'échantillonnage T16 et T18 étant connectés directement sur cette capacité d'échantillonnage additionnelle CA, son action est plus rapide que l'action de la capacité d'échantillonnage de sortie CE. La capacité d'échantillonnage de sortie CE apporte un filtrage des perturbations dues aux commutations des transistors.

Un autre avantage de l'échantillonneur-bloquer selon l'invention apparaît dans son état «bloqué ». En effet, dans l'état « bloqué », la capacité d'échantillonnage de sortie CE se trouve isolée de la tension d'entrée Vin car il n'y a plus de courant dans les transistors suiveurs T5 et T6 du premier étage de commutation 14.

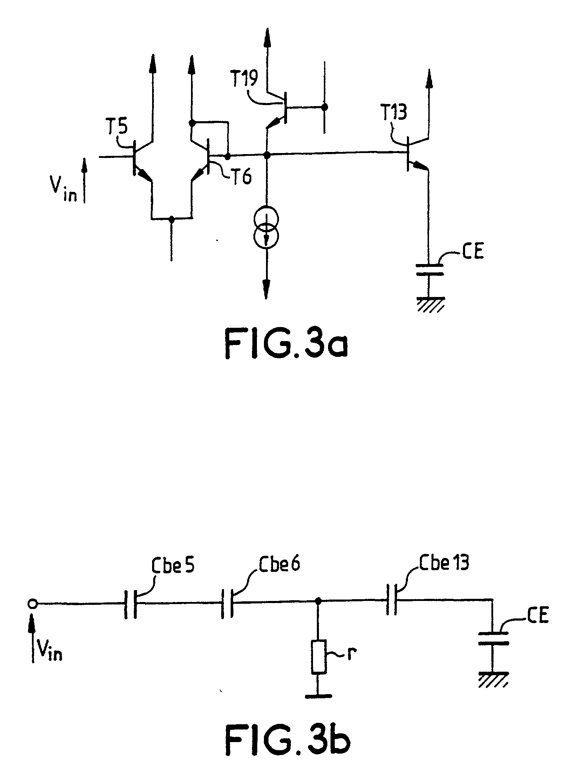

La figure 3a montre les éléments du schéma de la figure 2 devant assurer l'isolation en mode bloqué entre la tension d'entrée Vin et la tension sur la capacité d'échantillonnage de sortie CE, et la figure 3b le schéma « petit signal » équivalent.

La transmission du signal d'entrée s'effectue par les capacités base-émetteur Cbe5, Cbe6 et Cbe13 en série des transistors suiveurs T5 et T6 du premier étage de commutation et du premier transistor suiveur T13 du premier circuit d'échantillonnage. Les capacités Cbe5 et Cbe6 des transistors suiveurs T5 et T6 étant de plus court-circuitées vers la source d'alimentation par le transistor T19 de résistance r très faible à l'état passant, cette résistance valant :

$$r = Ut/Ic(Q19)$$

avec Ic(Q19) : courant collecteur dans le transistor Q19.

Les capacités Cbe5,Cbe6 (jonctions en inverse) sont très faibles, la résistance r est faible et on a un filtre passe haut dont le gain est très faible aux fréquences présentes dans le signal d'entrée Vin (impédance très élevée des capacités base-émetteur Cbe à ces fréquences). Ce passe haut est suivi d'un atténuateur capacitif de grand rapport constitué des capacités Cbe13 et de la capacité d'échantillonnage de sortie CE (Cbe13/(Cbe13+CE)), ce qui divise la perturbation résiduelle apparaissant au niveau de la résistance r (transistor T19) par un grand facteur. Il en résulte une excellente isolation en mode bloqué.

Il en est de même dans le second circuit d'échantillonnage symétrique (transistors suiveurs T9, T10 et le transistor T20).

Souvent, dans les échantillonneurs-bloqueurs de l'art antérieur, en mode bloqué, il existe une transmission du signal d'entrée Vin vers la capacité d'échantillonnage non négligeable que l'on cherche à compenser en créant une transmission de même amplitude et de signe opposé mais conduisant à une précision limitée.

Le décalage de la tension Vin échantillonnée (ou « pedestal ») est sensiblement annulé par la symétrie du circuit qui en outre, dans le schéma proposé selon l'invention, ne dépend pas de la tension Vin.

La tension d'échantillonnage aux bornes de la capacité d'échantillonnage de sortie CE est appliquée à l'entrée EA d'un amplificateur de lecture 18 ayant une grande impédance d'entrée afin d'éviter une décharge de la capacité d'échantillonnage de sortie CE.

L'amplificateur de lecture 18 comporte un étage d'entrée Darlington et un étage de sortie. L'étage d'entrée Darlington comporte un transistor d'entré T21 et un transistor de sortie T22 de types NPN, l'émetteur du transistor de sortie T22 étant connecté à une source de courant S 10 alimentée par la source d'alimentation négative, et son collecteur étant connecté à l'émetteur d'un transistor T23 de type NPN dont le collecteur se trouve relié à la source d'alimentation positive.

L'étage de sortie comporte un premier transistor T24 de type NPN ayant son collecteur connecté à une source de courant S9 alimentée par la source d'alimentation positive, son émetteur étant relié au collecteur et à la base d'un deuxième transistor T25 de même type, l'émetteur de ce dernier étant connecté à l'émetteur d'un troisième transistor T26 de type complémentaire PNP dont le collecteur se trouve relié à la source d'alimentation négative. La base du transistor T23 de l'étage d'entrée est connectée à la base et au collecteur du premier transistor T24 de l'étage de sortie et l'émetteur du transistor T22 de sortie du Darlington est connecté à la base du troisième transistor T26 de l'étage de sortie, la sortie S de l'échantillonneur-bloqueur 10 s'effectuant sur le collecteur du deuxième transistor T25.

La grande impédance d'entrée de l'amplificateur de lecture 18 permet de limiter la fuite de la capacité d'échantillonnage de sortie CE connectée à son entrée EA et ainsi de bénéficier d'une grande constante de temps de maintien du signal mémorisé par la capacité d'échantillonnage de sortie CE.

En outre l'amplificateur de lecture présente une capacité d'entrée de valeur sensiblement nulle. En effet en considérant que les tensions Vbe des différents transistors de l'amplificateur de lecture sont sensiblement identiques nous avons pour l'étage d'entrée, entre la base du transistor T23 et l'émetteur du transistor de sortie T22 du Darlington, une tension Vd1 égale à trois fois Vbe plus la tension collecteur base du transistor d'entrée T21 du Darlington et dans l'étage de sortie entre la base du transistor T24 et la base du transistor T26 une tension Vd2 égale à trois fois Vbe, Vd1 étant égale à Vd2 la tension collecteur base Vcb du transistor d'entrée du Darlington est sensiblement nulle ce qui, comme pour l'étage d'entrée suiveur 12, annule l'effet de la capacité d'entrée de l'étage d'entrée Darlington.

L'annulation ou neutrodynage de la capacité du transistor d'entrée T21 de l'amplificateur de lecture permet d'éviter son blocage lors des transitions rapides du signal.

Le potentiel continu de la sortie S de l'échantillonneur bloqueur est sensiblement identique au potentiel continu à l'entrée EA de l'amplificateur de lecture 18. En effet la tension Vin à l'entrée de l'amplificateur de lecture est décalée de - 2.Vbe vers le générateur de courant S10 par les transistors T21 et T22 et de + 2.Vbe vers la sortie S, par les transistors T26 et T25.

L'amplificateur de lecture décrit à titre d'exemple peut être remplacé par d'autres d'amplificateurs utilisant de technologies différentes par exemple des étages en technologie C-MOS à très faible consommation de courant.

L'utilisation d'une technologie bipolaire complémentaire et la conception du schéma électrique dans la réalisation de l'échantillonneur-bloqueur montrée à la figure 2, n'empile que deux tensions Vbe maximum entre l'entrée et la sortie de l'échantillonneur-bloqueur, ce qui présente l'avantage de traiter un niveau du signal d'entrée (pleine échelle) plus important pour une même tension d'alimentation. La réalisation décrite permet de traiter une dynamique de signal d'entrée de 2 volts crête à crête pour une tension d'alimentation de 5 volts.

La structure symétrique utilisant des transistors de type NPN et de type PNP réalise naturellement des étages en classe A/B. Ceci présente l'intérêt de consommer peu en statique avec la possibilité de disposer de beaucoup de courant (positif ou négatif) lors des changements de niveau sur les capacités. Lorsque le niveau final est atteint, le courant revient à sa valeur nominale, l'impédance de sortie de l'étage augmente et la bande de bruit est réduite.

Des résistances peuvent être mises en série avec les émetteurs de transistors d'échantillonnage de manière à limiter le facteur de surtension du circuit résonant constitué par la capacité d'échantillonnage et la partie inductive de l'impédance d'émetteur due à la coupure en fréquence du gain en courant $\beta$ du transistor.

Les structures de classe A/B, en conjonction avec l'utilisation rendue possible sous une tension d'alimentation de 5 volts, permettent d'atteindre une consommation très réduite sans limitation de la pente de variation du signal de sortie.

D'une façon générale l'échantillonneur-bloqueur selon l'invention présente des performances sensiblement améliorées par rapport aux performances des échantillonneurs-bloqueurs de l'art antérieur. Il comporte en particulier les avantages suivants : faible consommation, très bonne linéarité statique, grande bande passante, bruit limité, capacité d'entrée sensiblement nulle, distorsion limitable, bonne isolation, faible dérive et faibles perturbations au blocage, blocage et déblocage rapides, les performances optimales étant obtenues en échantillonnage sur les paliers de tension.

## Revendications

**1.** Echantillonneur-bloqueur (10) comportant un étage d'entrée suiveur (12) ayant une entrée (E) recevant une tension Vin à échantillonner et au moins une sortie (SV1,SV2), au moins un circuit d'échantillonnage ayant un étage de commutation (14,16), l'étage de commutation ayant au moins une entrée de commande (H1,H2,H3,H4), une entrée de signal (EC1,EC2) reliée à la sortie (SV1,SV2) de l'étage d'entrée suiveur (12), et une sortie (SC1,SC2), l'étage de commutation étant commandé par son entrée de commande (H1,H2,H3,H4) par une commande numérique pour être mis, soit dans un premier état dit « suiveur» où sa sortie suit le potentiel sur son entrée de signal, soit dans un deuxième état dit « isolé » où sa sortie (SC1,SC2) est isolée de son entrée de signal (EC1,EC2), la sortie de l'étage de commutation étant connectée à la base d'un premier transistor suiveur (T13,T14) dont l'émetteur est relié à une borne d'une capacité d'échantillonnage de sortie (CE) **caractérisé en ce que** le circuit d'échantillonnage comporte encore un deuxième transistor (Q6,T15,Q7,T17) ayant son émetteur alimenté par une source de courant (S7,S8) et ayant sa base reliée à un potentiel recopiant celui de la borne de la capacité d'échantillonnage de sortie (CE) et un troisième transistor (Q3,T19,T20) commandé par la commande numérique de manière à être parcouru par un courant lorsque l'étage de commutation (14,16) est dans l'état « isolé » et de manière à être bloqué lorsque l'étage de commutation est dans l'état «suiveur », le troisième transistor ayant son émetteur relié à la base du premier et sa base reliée à l'émetteur du deuxième.

**2.** Echantillonneur-bloqueur selon la revendication 1, **caractérisé en ce que** le circuit d'échantillonnage comporte une capacité d'échantillonnage additionnelle (CA) et un quatrième transistor suiveur (Q4,T16,Q5,T18) ayant sa base reliée à la sortie (SC1,SC2) de l'étage de commutation (14,16) et son émetteur relié à une borne de la capacité d'échantillonnage additionnelle (CA) pour appliquer à cette borne une tension recopiant le potentiel sur la borne de la capacité d'échantillonnage de sortie (CE), la base du deuxième transistor (T15,T17) étant reliée à la base de la capacité d'échantillonnage additionnelle (CA).

**3.** Echantilloneur-bloqueur selon la revendication 2, **caractérisé en ce que** la capacité d'échantillonnage additionnelle(CA) est de valeur plus faible que la capacité d'échantillonnage de sortie (CE).

**4.** Echantilloneur-bloqueur selon l'une des revendications 1 à 3, **caractérisé en ce que** dans un même circuit d'échantillonnage, les premier (T13,T14) et troisième transistors (T19,T20) sont d'un premier type et le deuxième (T15,T17) transistor est de type complémentaire.

**5.** Echantilloneur-bloqueur selon l'une des revendications 1 à 4, **caractérisé en ce que** l'étage d'entrée suiveur (12) effectue une recopie de la tension Vin avec un décalage de tension.

**6.** Echantilloneur-bloqueur selon l'une des revendications 1 à 5, **caractérisé en ce que** l'étage d'entrée suiveur (12) comporte deux sorties recopiant la tension d'entrée Vin, une première sortie (SV1) avec un décalage de tension positif et une seconde sortie (SV2) avec un décalage de tension négatif par rapport à l'entrée (E) de l'échantillonneur-bloqueur, ces deux sorties (SV1,SV2) étant reliées à la borne de la capacité d'échantillonnage de sortie (CE) par un circuit d'échantillonnage de constitution symétrique à deux voies qu'on appellera ci-après, premier et second circuit d'échantillonnage, le second étant constitué de manière identique au premier mais à partir de transistors de type complémentaires de ceux qui sont utilisés dans le premier circuit.

**7.** Echantilloneur-bloqueur selon la revendications 6, **caractérisé en ce que** l'entrée (E) de l'étage d'entrée suiveur (12) est reliée d'une part, à sa première sortie (SV1) par la base d'un transistor suiveur T1 de type NPN dont l'émetteur se trouve connecté à une première source de courant d'entrée S1 alimentée par une source d'alimentation négative et par l'émetteur d'un transistor suiveur T2 de type PNP, l'émetteur du transistor suiveur T2 de type PNP étant connecté à une seconde source de courant d'entrée S2 alimentée par une source d'alimentation positive et sa base reliée à l'entrée (E) de l'étage suiveur d'entrée (12), l'entrée (E) de l'étage d'entrée suiveur (12) étant reliée d'autre part à sa seconde sortie (SV2) par l'émetteur du transistor suiveur T1 de type NPN, un transistor T3 de type NPN, dont le collecteur est relié à une source d'alimentation positive est connecté par son émetteur au collecteur du transistor suiveur T1 de type NPN et par sa base à l'émetteur du transistor suiveur T2 de type PNP, un transistor T4 de type PNP ayant son collecteur relié à la source d'alimentation négative est connecté par son émetteur au collecteur du transistor suiveur T2 de type PNP, et par sa base à l'émetteur du transistor suiveur T1 de type NPN, les première et seconde sources de courant d'entrée S1,S2 imposant sensiblement les mêmes courants de polarisation I1 dans les transistors, faisant apparaître des potentiels de polarisation Vbe, entre la base et l'émetteur de chaque transistor, sensiblement identiques.

**8.** Echantilloneur-bloqueur selon la revendication 7, **caractérisé en ce que** la première sortie (SV1) de l'étage d'entrée suiveur (12) attaque une entrée (EC1) du premier étage de commutation (14) du premier circuit d'échantillonnage, et **en ce que** la seconde sortie (SV2) de l'étage d'entrée suiveur (12) attaque une entrée (EC2) d'un second étage de commutation (16) du second circuit d'échantillonnage symétrique du premier, le premier étage de commutation comportant une sortie (SC1) et deux entrées de commande, une première entrée de commande (H1) et une seconde entrée de commande (H2) ces deux entrées étant attaquées respectivement par des signaux de commutation complémentaires VC1 et VC2, fournis par une commande numérique, le premier étage de commutation (14) comportant en outre un premier transistor suiveur T5 de type NPN et un second transistor suiveur T6 de même type NPN, dont les émetteurs sont reliés entre eux, le collecteur du premier transistor suiveur T5 étant relié à la source d'alimentation positive et le collecteur du second transistor suiveur T6 à une source de courant S3 de valeur I1 alimentée par la source d'alimentation positive, la base du premier transistor suiveur T5 étant reliée à l'entrée (EC1) du premier l'étage de commutation (14) et la base du second transistor suiveur T6 étant reliée à la sortie (SC1) du même premier étage de commutation (14), un premier transistors de commutation T7 et un second transistor de commutation T8 ont leurs émetteurs reliés à une source de courant S4 de valeur 2.I1 alimentée par la source d'alimentation négative, le premier transistor de commutation T7 ayant son collecteur relié aux émetteurs des transistors suiveurs T5,T6 du premier étage de commutation, et sa base à la première entrée de commande (H1), le second transistor de commutation T8 ayant son collecteur relié à la base et au collecteur du second transistor suiveur T6 et sa base à la seconde entrée de commande (H2) et **en ce que** dans le second circuit d'échantillonnage, le second étage de commutation (16) symétrique du premier étage de commutation (14) est réalisé de façon identique au premier mais à partir de transistors T9, T10, T11 et T12 de type PNP complémentaire de ceux du premier étage de commutation (14) et de deux sources de courant S5, S6 respectivement de valeur I1 et 2.I1.

**9.** Echantilloneur-bloqueur selon l'une des revendications 6 à 8, **caractérisé en ce que** dans le premier circuit d'échantillonnage, la sortie de commutation (SC1) du premier étage de commutation (14) attaque la base d'un premier transistor suiveur T13 de type NPN, ayant son collecteur relié à la source d'alimentation positive et son émetteur relié à une première borne d'une capacité d'échantillonnage de sortie (CE) à travers une résistance R1, une seconde borne de la capacité d'échantillonnage de sortie (CE) étant connectée à une masse (M) de l'échantillonneur-bloqueur (10), un transistor T15 de type PNP, polarisé par son emetteur par une source de courant S7 de valeur I1, a sa base reliée à une première borne d'une capacité d'échantillonnage additionnelle (CA), la première borne de la capacité d'échantillonnage additionnelle étant connectée à l'émetteur d'un second transistor suiveur T16 de type NPN ayant son collecteur relié à la source d'alimentation positive et sa base reliée à la sortie (SC1) du premier étage de commutation (14), une seconde borne de la capacité d'échantillonnage additionnelle (CA) étant connectée à la masse (M) de l'échantillonneur-bloqueur, un transistor T19 de type NPN étant relié par son collecteur à la source d'alimentation positive, par son émetteur à la sortie (SC1) du premier étage de commutation (14) et par sa base à l'émetteur du transistor T15 de type PNP et **en ce que** dans le second circuit d'échantillonnage, la sortie de commutation (SC2) d'un second étage de commutation (16) attaque la base d'un premier transistor suiveur T14 de type PNP ayant le collecteur relié à la source d'alimentation négative, et son émetteur relié à la première borne de la capacité d'échantillonnage de sortie (CE) à travers une résistance R2 du second circuit d'échantillonnage, de valeur sensiblement identique à la valeur de la résistance R1 du premier circuit d'échantillonnage, et **en ce que** d'une façon symétrique un transistor T17 de type NPN ayant son émetteur connecté une source de courant S8 de valeur I1 alimentée par la source d'alimentation négative, son collecteur étant relié à la source d'alimentation positive et sa base étant reliée à la même première borne de la capacité d'échantillonnage additionnelle (CA) la première borne de la capacité d'échantillonnage additionnelle étant connectée à l'émetteur d'un second transistor suiveur T18 de type PNP, son collecteur étant relié à la source d'alimentation négative et sa base étant reliée à la sortie (SC2) du second étage de commutation (16), et **en ce que** d'une façon symétrique, un transistor T20 de type PNP est relié par son collecteur à la source d'alimentation négative, par son émetteur à la sortie (SC2) du second étage de commutation (16) et par sa base à l'émetteur du transistor T17 de type NPN.

10. Echantilloneur-bloqueur selon l'une des revendications 1 à 9, **caractérisé en ce qu'**il comporte un amplificateur de lecture (18) ayant une entrée (EA) et une sortie (S), la tension d'échantillonnage aux bornes de la capacité d'échantillonnage de sortie (CE) étant appliquée à l'entrée (EA) de l'amplificateur de lecture (18).

11. Echantilloneur-bloqueur selon la revendication 10, **caractérisé en ce** l'amplificateur de lecture (18) comporte un étage d'entrée Darlington et un étage de sortie, l'étage d'entrée Darlington ayant un transistor d'entrée T21 et un transistor de sortie T22 de types NPN, l'émetteur du transistor de sortie T22 étant connecté à une source de courant S10 alimentée par la source d'alimentation négative, et son collecteur étant connecté à l'émetteur d'un transistor T23 de type NPN de l'étage d'entrée, dont le collecteur se trouve relié à la source d'alimentation positive, l'étage de sortie comportant un premier transistor T24 de type NPN ayant son collecteur connecté à une source de courant S9 alimentée par la source d'alimentation positive, son émetteur relié au collecteur et à la base d'un deuxième transistor T25 de même type, l'émetteur de ce dernier étant connecté à l'émetteur d'un troisième transistor T26 de type complémentaire PNP dont le collecteur se trouve relié à la source d'alimentation négative, la base du transistor T23 de l'étage d'entrée étant connectée à la base et au collecteur du premier transistor T24 de l'étage de sortie et l'émetteur du transistor T22 de sortie du Darlington étant connecté à la base du troisième transistor T26 de l'étage de sortie, la sortie (S) de l'échantillonneur-bloqueur s'effectuant sur le collecteur du deuxième transistor T25 de l'étage de sortie.

**Patentansprüche**

1. Abtast- und Haltekreis (10), der eine Eingangs-Folgestufe (12) mit einem Eingang (E), der eine zu tastende Spannung Vin empfängt, und mit mindestens einem Ausgang (SV1, SV2), und mindestens eine Abtastschaltung aufweist, die eine Schaltstufe (14, 16) besitzt, wobei die Schaltstufe mindestens einen Steuereingang (H1, H2, H3, H4), einen Signaleingang (EC1, EC2), der mit dem Ausgang (SV1, SV2) der Eingangs-Folgestufe (12) verbunden ist, und einen Ausgang (SC1, SC2) besitzt, wobei die Schaltstufe über ihren Steuereingang (H1, H2, H3, H4) digital gesteuert wird, um entweder in einen ersten, so genannten "Folge"-Zustand, in dem ihr Ausgang dem Potential an ihrem Signaleingang folgt, oder in einen zweiten, so genannten "isolierten" Zustand gebracht zu werden, in dem ihr Ausgang (SC1, SC2) von ihrem Signaleingang (EC1, EC2) isoliert ist, wobei der Ausgang der Schaltstufe mit der Basis eines ersten Folgetransistors (T13, T14) verbunden ist, dessen Emitter mit einem Anschluss eines Ausgangs-Abtastkondensators (CE) verbunden ist, **dadurch gekennzeichnet, dass** die Abtastschaltung noch einen zweiten Transistor (Q6, T15, Q7, T17), dessen Emitter von einer Stromquelle (S7, S8) gespeist wird und dessen Basis mit einem Potential verbunden ist, das dasjenige des Anschlusses des Ausgangs-Abtastkondensators (CE) kopiert, und einen dritten Transistor (Q3, T19, T20) aufweist, der von der digitalen Steuerung derart gesteuert wird, dass er von einem Strom durchflossen wird, wenn die Schaltstufe (14, 16) sich im "isolierten" Zustand befindet, während er blockiert ist, wenn die Schaltstufe sich im "Folge"-Zustand befindet, wobei der Emitter des dritten Transistors mit der Basis des ersten und seine Basis mit dem Emitter des zweiten Transistors verbunden ist.

2. Abtast- und Haltekreis nach Anspruch 1, **dadurch gekennzeichnet, dass** die Abtastschaltung einen zusätzlichen Abtastkondensator (CA) und einen vierten Folgetransistor (Q4, T16, Q5, T18) aufweist, dessen Basis mit dem Ausgang (SC1, SC2) der Schaltstufe (14, 16) und dessen Emitter mit einem Anschluss des zusätzlichen Abtastkondensators (CA) verbunden ist, um an diesen Anschluss eine Spannung anzulegen, die das Potential am Anschluss des Ausgangs-Abtastkondensators (CE) kopiert, wobei die Basis des zweiten Transistors (T15, T17) mit der Basis des zusätzlichen Abtastkondensators (CA) verbunden ist.

3. Abtast- und Haltekreis nach Anspruch 2, **dadurch gekennzeichnet, dass** der zusätzliche Abtastkondensator (CA) einen geringeren Kapazitätswert hat als der Ausgangs-Abtastkondensator (CE).

4. Abtast- und Haltekreis nach einem der Ansprüche 1 bis 3, **dadurch gekennzeichnet, dass** in der gleichen Abtastschaltung der erste (T13, T14) und der dritte Transistor (T19, T20) von einem ersten Typ und der zweite Transistor (T15, T17) von einem komplementären Typ ist.

5. Abtast- und Haltekreis nach einem der Ansprüche 1 bis 4, **dadurch gekennzeichnet, dass** die Eingangs-Folgestufe (12) eine Kopie der Spannung Vin mit einer Spannungsverschiebung durchführt.

6. Abtast- und Haltekreis nach einem der Ansprüche 1 bis 5, **dadurch gekennzeichnet, dass** die Eingangs-Folgestufe (12) zwei Ausgänge aufweist, die die Eingangsspannung Vin kopieren, einen ersten Ausgang (SV1) mit einer positiven Spannungsverschiebung, und einen zweiten Ausgang (SV2) mit einer negativen Spannungsverschiebung bezüglich des Eingangs (E) des Abtast- und Haltekreises, wobei diese beiden Ausgänge (SV1, SV2) mit dem Anschluss des Ausgangs-Abtastkondensators (CE) über eine Abtastschaltung von symmetrischer Ausbildung mit zwei Kanälen verbunden ist, die nachfolgend erste und zweite Abtastschaltung genannt werden, wobei die zweite Schaltung gleich der ersten, aber ausgehend von Transistoren eines zu den in der ersten Schaltung verwendeten Transistoren komplementären Typs ausgebildet ist.

7. Abtast- und Haltekreis nach Anspruch 6, **dadurch gekennzeichnet, dass** der Eingang (E) der Eingangs-Folgestufe (12) einerseits mit deren erstem Ausgang (SV1) über die Basis eines Folgetransistors T1 vom Typ NPN, dessen Emitter mit einer ersten Eingangs-Stromquelle S1 verbunden ist, die von einer negativen Stromversorgungsquelle gespeist wird, und über den Emitter eines Folgetransistors T2 vom Typ PNP verbunden ist, wobei der Emitter des Folgetransistors T2 vom Typ PNP mit einer zweiten Eingangs-Stromquelle S2 verbunden ist, die von einer positiven Stromversorgungsquelle gespeist wird, und seine Basis mit dem Eingang (E) der Eingangs-Folgestufe (12) verbunden ist, während der Eingang (E) der Eingangs-Folgestufe (12) andererseits mit deren zweitem Ausgang (SV2) über den Emitter des Folgetransistors T1 vom Typ NPN verbunden ist, wobei ein Transistor T3 vom Typ NPN, dessen Kollektor mit einer positiven Stromversorgungsquelle verbunden ist, über seinen Emitter mit dem Kollektor des Folgetransistors T1 vom Typ NPN und über seine Basis mit dem Emitter des Folgetransistors T2 vom Typ PNP verbunden ist, wobei ein Transistor T4 vom Typ PNP, dessen Kollektor mit der negativen Stromversorgungsquelle verbunden ist, über seinen Emitter mit dem Kollektor des Folgetransistors T2 vom Typ PNP und über seine Basis mit dem Emitter des Folgetransistors T1 vom Typ NPN verbunden ist, und wobei die erste und die zweite Eingangsstromquelle S1, S2 im Wesentlichen die gleichen Polarisationsströme I1 in die Transistoren einspeisen, wodurch sich Polarisationspotentiale Vbe zwischen der Basis und dem Emitter jedes Transistors ergeben, die im Wesentlichen gleich sind.

8. Abtast- und Haltekreis nach Anspruch 7, **dadurch gekennzeichnet, dass** der erste Ausgang (SV1) der Eingangs-Folgestufe (12) einen Eingang (EC1) der ersten Schaltstufe (14) der ersten Abtastschaltung steuert, und dass der zweite Ausgang (SV2) der Eingangs-Folgestufe (12) einen Eingang (EC2) einer zweiten Schaltstufe (16) der zweiten Abtastschaltung steuert, die symmetrisch zur ersten ist, wobei die erste Schaltstufe einen Ausgang (SC1) und zwei Steuereingänge, einen ersten Steuereingang (H1) und einen zweiten Steuereingang (H2), aufweist, wobei diese beiden Eingänge von komplementären Schaltsignalen VC1 und VC2 gesteuert werden, die von einer digitalen Steuerung geliefert werden, wobei die erste Schaltstufe (14) außerdem einen ersten Folgetransistor T5 vom Typ NPN und einen zweiten Folgetransistor T6 vom gleichen Typ NPN aufweist, deren Emitter miteinander verbunden sind, wobei der Kollektor des ersten Folgetransistors T5 mit der positiven Stromversorgungsquelle und der Kollektor des zweiten Folgetransistors T6 mit einer Stromquelle S3 des Werts I1 verbunden ist, die von der positiven Stromversorgungsquelle gespeist wird, wobei die Basis des ersten Folgetransistors T5 mit dem Eingang (EC1) der ersten Schaltstufe (14) und die Basis des zweiten Folgetransistors T6 mit dem Ausgang (SC1) der gleichen ersten Schaltstufe (14) verbunden ist, wobei die Emitter eines ersten Schalttransistors T7 und eines zweiten Schalttransistors T8 mit einer Stromquelle S4 des Werts 2.I1 verbunden sind, die von der negativen Stromversorgungsquelle gespeist wird, wobei der Kollektor des ersten Schalttransistors T7 mit den Emittern der Folgetransistoren T5, T6 der ersten Schaltstufe und seine Basis mit dem ersten Steuereingang (H1) verbunden ist, wobei der Kollektor des zweiten Schalttransistors T8 mit der Basis und mit dem Kollektor des zweiten Folgetransistors T6 und seine Basis mit dem zweiten Steuereingang (H2) verbunden ist, und dass in der zweiten Abtastschaltung die zweite Schaltstufe (16), die zur ersten Schaltstufe (14) symmetrisch ist, in gleicher Weise wie die erste, aber ausgehend von Transistoren T9, T10, T11 und T12 vom Typ PNP, die zu denjenigen der ersten Schaltstufe (14) komplementär sind, und von zwei Stromquellen S5, S6 mit dem Wert I1 bzw. 2.I1 hergestellt wird.

9. Abtast- und Haltekreis nach einem der Ansprüche 6 bis 8, **dadurch gekennzeichnet, dass** in der ersten Abtastschaltung der Schaltausgang (SC1) der ersten Schaltstufe (14) die Basis eines ersten Folgetransistors T13 vom Typ NPN steuert, dessen Kollektor mit der positiven Stromversorgungsquelle und dessen Emitter mit einem ersten Anschluss eines Ausgangs-Abtastkondensators (CE) über einen Widerstand R1 verbunden ist, während ein zweiter Anschluss des Ausgangs-Abtastkondensators (CE) mit einer Masse (M) des Abtast- und Haltekreises (10) verbunden ist, wobei die Basis eines Transistors T15 vom Typ PNP, der über seinen Emitter von einer Stromquelle S7 des Werts I1 polarisiert wird, mit einem ersten Anschluss eines zusätzlichen Abtastkondensators (CA) verbunden ist, wobei der erste Anschluss des zusätzlichen Abtastkondensators mit dem Emitter eines zweiten Folgetransistors T16 vom Typ NPN verbunden ist, dessen Kollektor mit der positiven Stromversorgungsquelle und dessen Basis mit dem Ausgang (SC1) der ersten Schaltstufe (14) verbunden ist, wobei ein zweiter Anschluss des zusätzlichen Abtastkondensators (CA) mit der Masse (M) des Abtast- und Haltekreises verbunden ist, wobei ein Transistor T19 vom Typ NPN über seinen Kollektor mit der positiven Stromversorgungsquelle, über seinen Emitter mit dem Ausgang (SC1) der ersten Schaltstufe (14) und über seine Basis mit dem Emitter des Transistors T15 vom Typ PNP verbunden ist, und dass in der zweiten Abtastschaltung der Schaltausgang (SC2) einer zweiten Schaltstufe (16) die Basis eines ersten Folgetransistors T14 vom Typ PNP steuert, dessen Kollektor mit der negativen Stromversorgungsquelle und dessen Emitter mit dem ersten Anschluss des Ausgangs-Abtastkondensators (CE) über einen Widerstand R2 der zweiten Abtastschaltung verbunden ist, dessen Wert im Wesentlichen gleich dem Wert des Widerstands R1 der ersten Abtastschaltung ist, und dass in symmetrischer Weise der Emitter eines Transistors T17 vom Typ NPN mit einer Stromquelle S8 des Werts I1 verbunden ist, die von der negativen Stromversorgungsquelle gespeist wird, während sein Kollektor mit der positiven Stromversorgungsquelle und seine Basis mit dem gleichen ersten Anschluss des zusätzlichen Abtastkondensators (CA) verbunden ist, wobei der erste Anschluss des zusätzlichen Abtastkondensators mit dem Emitter eines zweiten Folgetransistors T18 vom Typ PNP verbunden ist, dessen Kollektor mit der negativen Stromversorgungsquelle und dessen Basis mit dem Ausgang (SC2) der zweiten Schaltstufe (16) verbunden ist, und dass in symmetrischer Weise ein Transistor T20 vom Typ PNP über seinen Kollektor mit der negativen Stromversorgungsquelle, über seinen Emitter mit dem Ausgang (SC2) der zweiten Schaltstufe (16) und über seine Basis mit dem Emitter des Transistors T17 vom Typ NPN verbunden ist.

10. Abtast- und Haltekreis nach einem der Ansprüche 1 bis 9, **dadurch gekennzeichnet, dass** er einen Leseverstärker (18) aufweist, der einen Eingang (EA) und einen Ausgang (S) aufweist, wobei die Abtastspannung an den Anschlüssen des Ausgangs-Abtastkondensators (CE) an den Eingang (EA) des Leseverstärkers (18) angelegt wird.

11. Abtast- und Haltekreis nach Anspruch 10, **dadurch gekennzeichnet, dass** der Leseverstärker (18) eine Darlington-Eingangsstufe und eine Ausgangsstufe aufweist, wobei die Darlington-Eingangsstufe einen Eingangstransistor T21 und einen Ausgangstransistor T22 vom Typ NPN aufweist, wobei der Emitter des Ausgangstransistors T22 mit einer Stromquelle S10 verbunden ist, die von der negativen Stromversorgungsquelle gespeist wird, und sein Kollektor mit dem Emitter eines Transistors T23 vom Typ NPN der Eingangsstufe verbunden ist, dessen Kollektor mit der positiven Stromversorgungsquelle verbunden ist, wobei die Ausgangsstufe einen ersten Transistor T24 vom Typ NPN aufweist, dessen Kollektor mit einer Stromquelle S9 verbunden ist, die von der positiven Stromversorgungsquelle gespeist wird, dessen Emitter mit dem Kollektor und der Basis eines zweiten Transistors T25 vom gleichen Typ verbunden ist, wobei der Emitter dieses letzteren mit dem Emitter eines dritten Transistors T26 vom komplementären Typ PNP verbunden ist, dessen Kollektor mit der negativen Stromversorgungsquelle verbunden ist, wobei die Basis des Transistors T23 der Eingangsstufe mit der Basis und mit dem Kollektor des ersten Transistors T24 der Ausgangsstufe, und der Emitter des Ausgangstransistors T22 der Darlington-Eingangsstufe mit der Basis des dritten Transistors T26 der Ausgangsstufe verbunden ist, wobei der Ausgang (S) des Abtast- und Haltekreises am Kollektor des zweiten Transistors T25 der Ausgangsstufe liegt.

**Claims**

1. Sampler-blocker (10) including a follower input stage (12) having an input (E) receiving a voltage Vin to be sampled and at least one output (SV1, SV2), at least one sampling circuit having a switching stage (14, 16), the switching stage having at least one control input (H1, H2, H3, H4), a signal input (EC1, EC2) linked to the output (SV1, SV2) of the follower input stage (12), and one output (SC1, SC2), the switching stage being controlled by its control input (H1, H2, H3, H4) by a digital control to be placed, either in a first "follower" state where its output follows the potential on its signal input, or in a second "isolated" state where its output (SC1, SC2) is isolated from its signal input (EC1, EC2), the output of the switching stage being connected to the base of a first follower transistor (T13, T14), the emitter of which is linked to a terminal of an output sampling capacitor (CE), **characterized in that** the sampling circuit also includes a second transistor (Q6, T15, Q7, T17) having its emitter powered by a current source (S7, S8) and having its base linked to a potential copying that of the terminal of the output sampling capacitor (CE) and a third transistor (Q3, T19, T20) controlled by the digital control so as to be passed through by a current when the switching stage (14, 16) is in the "isolated" state and to be blocked when the switching stage is in the "follower" state, the third transistor having its emitter linked to the base of the first and its base linked to the emitter of the second.

2. Sampler-blocker according to Claim 1, **characterized in that** the sampling circuit includes an additional sampling capacitor (CA) and a fourth follower transistor (Q4, T16, Q5, T18) having its base linked to the output (SC1, SC2) of the switching stage (14, 16) and its emitter linked to a terminal of the additional sampling capacitor (CA) to apply to this terminal a voltage copying the potential on the terminal of the output sampling capacitor (CE), the base of the second transistor (T15, T17) being linked to the base of the additional sampling capacitor (CA).

3. Sampler-blocker according to Claim 2, **characterized in that** the additional sampling capacitor (CA) is of a lower value than the output sampling capacitor (CE).

4. Sampler-blocker according to one of Claims 1 to 3, **characterized in that** in one and the same sampling circuit, the first transistor (T13, T14) and the third transistor (T19, T20) are of a first type and the second transistor (T15, T17) is of complementary type.

5. Sampler-blocker according to one of Claims 1 to 4, **characterized in that** the follower input stage (12) makes a copy of the voltage Vin with a voltage offset.

6. Sampler-blocker according to one of Claims 1 to 5, **characterized in that** the follower input stage (12) includes two outputs copying the input voltage Vin, a first output (SV1) with a positive voltage offset and a second output (SV2) with a negative voltage offset relative to the input (E) of the sampler-blocker, these two outputs (SV1, SV2) being linked to the terminal of the output sampling capacitor (CE) by a symmetrically-constructed sampling circuit with two channels referred to below as first and second sampling circuits, the second being constructed identically to the first but from transistors of a type complementing those used in the first circuit.

7. Sampler-blocker according to Claim 6, **characterized in that** the input (E) of the follower input stage (12) is linked on the one hand to its first output (SV1) by the base of an NPN type follower transistor T1, the emitter of which is connected to a first input current source S1 powered by a negative power source and by the emitter of a PNP type follower transistor T2, the emitter of the PNP type follower transistor T2 being connected to a second input current source S2 powered by a positive power source and its base linked to the input (E) of the input follower stage (12), the input (E) of the follower input stage (12) being linked on the other hand to its second output (SV2) by the emitter of the NPN type follower transistor T1, an NPN type transistor T3, the collector of which is linked to a positive power source, is connected by its emitter to the collector of the NPN type follower transistor T1 and by its base to the emitter of the PNP type follower transistor T2, a PNP type transistor T4, the collector of which is linked to the negative power source, is connected by its emitter to the collector of the PNP type follower transistor T2, and by its base to the emitter of the NPN type follower transistor T1, the first and second input current sources S1, S2 imposing roughly the same bias currents I1 in the transistors, revealing bias potentials Vbe, between the base and the emitter of each transistor, that are roughly the same.

8. Sampler-blocker according to Claim 7, **characterized in that** the first output (SV1) of the follower input stage (12) drives an input (EC1) of the first switching stage (14) of the first sampling circuit, and **in that** the second output (SV2) of the follower input stage (12) drives an input (EC2) of a second switching stage (16) of the second sampling circuit symmetrical to the first, the first switching stage including an output (SC1) and two control inputs, a first control input (H1) and a second control input (H2), these two inputs being driven respectively by complementary switching signals VC1 and VC2, supplied by a digital control, the first switching stage (14) also including a first NPN type follower transistor T5 and a second NPN type follower transistor T6, the emitters of which are linked to each other, the collector of the first follower transistor T5 being linked to the positive power source and the collector of the second follower transistor T6 being linked to a current source S3 of value I1 powered by the positive power source, the base of the first follower transistor T5 being linked to the input (EC1) of the first switching stage (14) and the base of the second follower transistor T6 being linked to the output (SC1) of the first switching stage (14), a first switching transistor T7 and a second switching transistor T8 have their emitters linked to a current source S4 of value 2.I1 powered by the negative power source, the first switching transistor T7 having its collector linked to the emitters of the follower transistors T5, T6 of the first switching stage, and its base to the first control input (H1), the second switching transistor T8 having its collector linked to the base and to the collector of the second follower transistor T6 and its base to the second control input (H2), and **in that**, in the second sampling circuit, the second switching stage (16) symmetrical to the first switching stage (14) is produced identically to the first but from PNP type transistors T9, T10, T11 and T12 complementing those of the first switching stage (14) and from two current sources S5, S6 respectively of value I1 and 2.I1.

9. Sampler-blocker according to one of Claims 6 to 8, **characterized in that** in the first sampling circuit, the switching output (SC1) of the first switching stage (14) drives the base of a first NPN type follower transistor T13, having its collector linked to the positive power source and its emitter linked to a first terminal of an output sampling capacitor (CE) through a resistor R1, a second terminal of the output sampling capacitor (CE) being connected to a ground (M) of the sampler-blocker (10), a PNP type transistor T15, biased by its emitter by a current source S7 of value I1, has its base linked to a first terminal of an additional sampling capacitor (CA), the first terminal of the additional sampling capacitor being connected to the emitter of a second NPN type follower transistor T16 having its collector linked to the positive power source and its base linked to the output (SC1) of the first switching stage (14), a second terminal of the additional sampling capacitor (CA) being connected to the ground (M) of the sampler-blocker, an NPN type transistor T19 being linked by its collector to the positive power source, by its emitter to the output (SC1) of the first switching stage (14) and by its base to the emitter of the PNP type transistor T15, and **in that**, in the second sampling circuit, the switching output (SC2) of a second switching stage (16) drives the base of a first PNP type follower transistor T14 having the collector linked to the negative power source, and its emitter linked to the first terminal of the output sampling capacitor (CE) through a resistor R2 of the second sampling circuit, of a value roughly the same as that of the resistor R1 of the first sampling circuit, and **in that**, symmetrically, an NPN type transistor T17 has its emitter connected to a current source S8 of value I1 powered by the negative power source, its collector being linked to the positive power source and its base being linked to the same first terminal of the additional sampling capacitor (CA), the first terminal of the additional sampling capacitor being connected to the emitter of a second PNP type follower transistor T18, its collector being linked to the negative power source and its base being linked to the output (SC2) of the second switching stage (16), and **in that**, symmetrically, a PNP type transistor T20 is linked by its collector to the negative power source, by its emitter to the output (SC2) of the second switching stage (16) and by its base to the emitter of the NPN type transistor T17.

10. Sampler-blocker according to one of Claims 1 to 9, **characterized in that** it includes a read amplifier (18) having an input (EA) and an output (S), the sampling voltage at the terminals of the output sampling capacitor (CE) being applied to the input (EA) of the read amplifier (18).

11. Sampler-blocker according to Claim 10, **characterized in that** the read amplifier (18) includes a Darlington input stage and an output stage, the Darlington input stage having an input transistor T21 and an output transistor T22, both of NPN type, the emitter of the output transistor T22 being connected to a current source S10 powered by the negative power source, and its collector being connected to the emitter of an NPN type transistor T23 of the input stage, the collector of which is linked to the positive power source, the output stage including a first NPN type transistor T24 having its collector connected to a current source S9 powered by the positive power source, its emitter linked to the collector and to the base of a second transistor T25 of the same type, the emitter of the latter being connected to the emitter of a third complementary PNP type transistor T26, the collector of which is linked to the negative power source, the base of the transistor T23 of the input stage being connected to the base and to the collector of the first transistor T24 of the output stage and the emitter of the Darlington output transistor T22 being connected to the base of the third transistor T26 of the output stage, the output (S) of the sampler-blocker being via the collector of the second transistor T25 of the output stage.

FIG.1a

FIG.1b

FIG.1c

FIG.2

EP 1 039 477 B1

FIG.3a

FIG.3b